# EUROPÄISCHE PATENTSCHRIFT

(11) **EP 2 395 550 B1**
(45) Veröffentlichungstag und Bekanntmachung des Hinweises auf die Patenterteilung: **09.10.2013**
(21) Anmeldenummer: 10165349.1
(22) Anmeldetag: 09.06.2010
(51) Int. Cl.: H01L 25/00, H01L 31/0224, H01L 31/042, H02N 6/00

(54) **Verfahren zum Erkennen und Beurteilen von Verschattungen**
Method for recognising and evaluating shadowing
Procédé de reconnaissance et d'évaluation d'obscurcissements

(43) Veröffentlichungstag der Anmeldung: 14.12.2011
(73) Patentinhaber: SMA Solar Technology AG, 34266 Niestetal (DE)
(72) Erfinder: Klein, Jens, 37075 Göttingen (DE); Magnussen, Björn, Dr.-Ing., 34131 Kassel (DE); Strusch, Andreas, 34233 Ihringshausen (DE); Smith, Alexander, B.Sc., New York, NY 10025 (US); Gaggioli, William, B.Sc., Mission Viejo, CA 92692 (US)
(74) Vertreter: Rehberg Hüppe + Partner

(56) Entgegenhaltungen:
- EP-A2- 1 429 394
- WO-A2-2006/079503
- DE-A1-102006 008 178
- US-A- 5 637 155
- US-A1- 2009 177 458
- US-B1- 7 305 983

## Beschreibung

Die Erfindung bezieht sich auf ein Verfahren zum Erkennen und Beurteilen von Verschattungen bei mindestens einem Solarmodul mit den Merkmalen des Oberbegriffs des unabhängigen Patentanspruchs 1.

Bei der vorliegenden Erfindung geht es also primär darum, eine Verschattung eines Solarmoduls zu erkennen und dabei insbesondere von anderen Gründen zu trennen, aus denen das Solarmodul eine andere als seine bei dem Sonnenstand an dem aktuellen Tag maximal mögliche elektrische Leistung abgibt. Unter einer Verschattung wird dabei ein Schattenwurf durch ein zumindest im Wesentlichen lichtundurchlässiges, insbesondere stationäres Hindernis zwischen dem Solarmodul und der Sonne verstanden. Wolken rufen nach dieser Definition keine Verschattung des Solarmoduls hervor. Bei der sich optional anschließenden Beurteilung einer erkannten Verschattung geht es insbesondere darum, deren Tragweite zu erfassen, indem z. B. die in einem Jahr aufgrund der Verschattung nicht realisierte Energiemenge quantifiziert wird. Auf dieser Basis können dann z. B. Entscheidungen über die Beseitigung von Hindernissen getroffen werden, die die Verschattung verursachen.

Mit dem Begriff Solarmodul wird in der Definition der Erfindung in den Patentansprüchen und in der vorliegenden Beschreibung eine Einheit bezeichnet, bei der es sich um eine Reihen- und/oder Parallelschaltung von einzelnen Solarzellen handelt, deren elektrische Leistung gemeinsam, d. h. über gemeinsame Leitungen, abgeführt wird und die beispielsweise in einem sogenannten Solarpaneel körperlich zusammengefasst sein können. Ein solches Solarmodul kann auch auf mehrere einzelne Solarpaneele aufgeteilt sein, die nur anschlusstechnisch zusammengefasst sind. Ebenso kann ein Solarpaneel mehrere derartige Solarmodule umfassen, wenn hierfür einzelne Anschlussleitungen und entsprechende Möglichkeiten zur Erfassung der Leistung von den einzelnen Solarmodulen vorhanden sind.

Soweit in der Definition der Erfindung in den Patentansprüchen und in der vorliegenden Beschreibung der Begriff "Sonnenstand" verwendet wird, so soll dieser auch die Bedeutung "Tageszeit" einschließen. Anders gesagt kann als Maß für den Sonnenstand auch die Uhrzeit an dem jeweiligen Tag verwendet werden, und dabei können Änderungen des Sonnenstands bei derselben Uhrzeit an aufeinanderfolgenden Tagen unberücksichtigt bleiben, obwohl dies nicht ideal ist.

Weiterhin ist in der Definition der vorliegenden Erfindung in den Patentansprüchen und in der nachfolgenden Beschreibung die Formulierung "Erfassen der von dem jeweiligen Solarmodul abgegebenen elektrischen Leistung" nicht so eng zu verstehen, dass zwingend die tatsächliche elektrische Leistung erfasst werden muss. Vielmehr ist es ausreichend, einen elektrischen Parameter zu erfassen, der sich - idealerweise, aber nicht notwendigerweise - proportional mit der von dem Solarmodul abgegebenen elektrischen Leistung ändert. Ein solcher Parameter kann selbst dann statt der abgegebenen elektrischen Leistung bei dem neuen Verfahren verwendet werden, wenn er sich nicht eindeutig in die abgegebene elektrische Leistung umrechnen lässt. Da bei der vorliegenden Erfindung jedoch auch etwaige Leistungsverluste durch Verschattungen der Solarmodule von Interesse sind, ist es jedoch bevorzugt, wenn sich die elektrische Leistung aus dem verwendeten Parameter berechnen lässt.

### STAND DER TECHNIK

Aus der DE 201 02 619 U1 ist eine Anzeige für Energieerzeugungsanlagen bekannt, die ein Verfahren mit dem Merkmal des Oberbegriffs des unabhängigen Patentanspruchs 1 implementiert. Dazu wird zunächst eine Tagessollkurve der von einer Photovoltaikanlage bereitgestellten Leistung berechnet und dann kontinuierlich durch Lernen von fehlerfreien Istzuständen an die tatsächlich mögliche Leistung der speziellen Photovoltaikanlage angepasst. Voraussetzung für diese Vorgehensweise ist die Einbindung einer zusätzlichen Lichtmesseinheit zur Erfassung der jeweils tatsächlich vorhandenen Einstrahlungsstärke. Die Berechnung der ersten Tagessollkurve erfolgt nach dem Ort der Photovoltaikanlage (Breiten- und Längengrad) sowie dem täglich oder monatlich angepassten Sonnestand. Auf diese Weise gehen auch umgebungsbedingte Einschränkungen bei der optimalen Ausrichtung der Solarmodule der Photovoltaikanlage in die effektive Tageskurve ein. Weicht der Istwert nach der Lernphase über ein einstellbares Maß von der gelernten Sollkurve ab, wird der Anwender hierauf hingewiesen. Verschattungen von Solarmodulen der Photovoltaikanlage gehen bei der bekannten Anzeige in die gelernte Sollkurve ein, sie werden aber weder als solche erkannt oder noch hinsichtlich Ihrer Bedeutung bewertet.

Aus der DE 10 2006 008 178 A1 ist ein Verfahren zur Kontrolle von Photovoltaikanlagen mit mehreren Solarmodulen bekannt. Dabei werden zur permanenten Leistungskontrolle Vergleichsmessungen zwischen den Solarmodulen durchgeführt. Treten Abweichungen zwischen den Messwerten auf, wird dies als Hinweis gesehen, dass die Photovoltaikanlage einer Überprüfung bedarf. Dabei ist zu unterscheiden, ob es sich um umweltbedingte Störungen wie Verschattungseffekte durch Wolken, Bäume oder Immobilien handelt, oder um irreversible mechanische oder elektrische Schädigungen. Einzelheiten zu dieser Unterscheidung sind der DE 10 2006 008 178 A1 jedoch nicht zu entnehmen.

### AUFGABE DER ERFINDUNG

Der Erfindung liegt die Aufgabe zugrunde, ein Verfahren mit den Merkmalen des Oberbegriffs des unabhängigen Patentanspruchs 1 aufzuzeigen, das in der Lage ist, Verschattungen eines Solarmoduls mit hoher Sicherheit zu erkennen, und das damit eine Grundlage für eine sinnvolle Beurteilung der Auswirkungen der jeweiligen Verschattung bereitstellt.

### LÖSUNG

Die Aufgabe der Erfindung wird durch ein Verfahren mit den Merkmalen des unabhängigen Patentanspruchs 1 gelöst. Bevorzugte Ausführungsformen des neuen Verfahrens sind in den abhängigen Patentansprüchen 2 bis 15 beschrieben.

### BESCHREIBUNG DER ERFINDUNG

Ausgehend von einem Verfahren mit den Schritten: Erfassen der von mindestens einem Solarmodul abgegebenen elektrischen Leistung; Bestimmen eines idealen Leistungsverlaufs der elektrischen Leistung über einen aktuellen Tag auf Basis der für einander entsprechende Sonnenstände während einer Anzahl von vergangenen Tagen erfassten elektrischen Leistung; und Ermittlung von Abweichungen der von dem Solarmodul während des aktuellen Tages abgegebenen elektrischen Leistung von dem idealen Leistungsverlauf stellt die vorliegende Erfindung ein Verfahren zum Erkennen und Beurteilen von Verschattungen bei dem mindestens einen Solarmodul bereit, indem der ideale Leistungsverlauf wolkenfreier Sonne ohne Schatten werfende Hindernisse über den ganzen Tag entspricht und an für die einander entsprechende Sonnenstände erfasste Spitzenwerte der elektrischen Leistung während der Anzahl von vergangenen Tagen angefittet wird; indem für jeden Sonnenstand am aktuellen Tag ein Erwartungswert der von dem Solarmodul abgegebenen elektrischen Leistung definiert wird; und indem für alle Sonnenstände, bei denen die von dem Solarmodul während des aktuellen Tages abgegebene elektrische Leistung unter dem idealen Leistungsverlauf bleibt, eine Verschattungswahrscheinlichkeit größer oder gleich null festgelegt wird, deren Höhe von dem Maß an Übereinstimmung der von dem Solarmodul bei dem Sonnenstand abgegebenen elektrischen Leistung mit dem Erwartungswert abhängt.

Bei dem neuen Verfahren werden Verschattungen des Solarmoduls aufgrund der Betriebsdaten des Solarmoduls erkannt, d. h. ohne beispielsweise einen zusätzlichen Einstrahlungs- bzw. Verschattungssensor zu verwenden. Ermöglicht wird dies, indem durch die erfindungsgemäße Vorgehensweise effektiv statistische Schwankungen von dem erwarteten Leistungsverlauf des Solarmoduls separiert werden, der so nur noch systematische Schwankungen der elektrischen Leistung umfasst. Der Vergleich dieses erwarteten Leistungsverlaufs mit dem für das konkrete Solarmodul ermittelten idealen Leistungsverlauf, erlaubt es dann mit hoher Sicherheit, Rückschlüsse auf Verschattungen des Solarmoduls bei bestimmten Sonnenständen zu ziehen.

Konkret kann dabei der Erwartungswert für jeden Sonnenstand als Spitzenwert der elektrischen Leistung bei den ihm entsprechenden Sonnenständen während der Anzahl von vergangenen Tagen definiert werden, und die Höhe der Verschattungswahrscheinlichkeit kann in diesem Fall mit ansteigendem Maß an Übereinstimmung der von dem Solarmodul bei dem jeweiligen Sonnenstand abgegebenen elektrischen Leistung mit dem Erwartungswert zunehmen.

In jedem Fall wird bei dem neuen Verfahren ein idealer Leistungsverlauf bestimmt. Hierzu werden in der Vergangenheit erfasste tatsächliche Leistungen von dem Solarmodul oder den Solarmodulen verwendet. Indem dabei nur Spitzenwerte der elektrischen Leistung bei dem jeweiligen Sonnenstand berücksichtigt werden, werden automatisch nur elektrische Leistungen ohne Bewölkung oder allenfalls bei minimaler Bewölkung berücksichtigt. Auch diese Spitzenwerte weisen aber den Einfluss von Verschattungen auf die elektrische Leistung des Solarmoduls auf, falls es solche bei bestimmten Sonnenständen gibt. Um den Einfluss dieser Verschattungen zu unterdrücken, wird an die Spitzenwerte der elektrischen Leistung während der Anzahl von vergangenen Tagen eine Idealkurve für den idealen Leistungsverlauf angefittet, der wolkenfreier Sonne ohne Schatten werfende Hindernisse über den ganzen Tag entspricht. Als die Idealkurve kann eine einfache Parabel verwendet werden; sie kann aber beispielsweise auch aus einem physikalischen Modell des Solarmoduls, optional unter Berücksichtigung des Standorts und/oder der Ausrichtung des Solarmoduls generiert werden. Dabei können die Spitzenwerte im Rahmen der vorliegenden Erfindung vor dem Anfitten des idealen Leistungsverlaufs geglättet oder gefiltert werden, indem beispielsweise Mittelwerte über die höchsten elektrischen Leistungen bei dem jeweiligen Sonnenstand gebildet werden oder sogar die absoluten Spitzenwerte als Ausreißer verworfen werden und nur die darunterliegenden höchsten elektrischen Leistungen Berücksichtigung finden. Das Anfitten selbst kann unter Anwendung irgendeines bekannten Algorithmus erfolgen. Der derart bestimmte ideale Leistungsverlauf der elektrischen Leistung über den Tag wird verwendet, um Sonnenstände zu erfassen, bei denen die von den jeweiligen Solarmodulen während des aktuellen Tages abgegebene elektrische Leistung hinter dem idealen Leistungsverlauf zurückbleibt. Nur dann besteht überhaupt die Wahrscheinlichkeit einer Verschattung.

Um die Ursache für das Unterschreiten des idealen Leistungsverlaufs zu erkennen, wird bei dem neuen Verfahren zusätzlich ein Erwartungswert der von dem Solarmodul abgegebenen elektrischen Leistung definiert. Hierbei handelt es sich, wenn nur ein Solarmodul betrachtet wird, um den bereits angesprochenen Spitzenwert der elektrischen Leistung bei dem entsprechenden Sonnenstand während der Anzahl von vergangenen Tagen. Wenn dieser Spitzenwert, der, wie bereits im Zusammenhang mit der Bestimmung des idealen Leistungsverlaufs der elektrischen Leistung angesprochen wurde, geglättet oder gefiltert sein kann, erreicht wird und der ideale Leistungsverlauf dennoch unterschritten wird, bedeutet dies, dass die von dem Solarmodul abgegebene elektrische Leistung bei dem entsprechenden Sonnenstand immer hinter dem idealen Leistungsverlauf zurückbleibt, und zwar an jedem wolkenfreien Tag um dasselbe Maß. Basierend auf dieser Überlegung wird bei dem neuen Verfahren für jeden Sonnenstand, bei dem die von dem Solarmodul während des aktuellen Tages abgegebene elektrische Leistung hinter dem idealen Leistungsverlauf zurückbleibt, eine Verschattungswahrscheinlichkeit größer oder gleich null festgelegt, deren konkrete Höhe von dem Maß an Übereinstimmung der von dem Solarmodul bei dem Sonnenstand abgegebenen elektrischen Leistung mit dem Erwartungswert abhängt. Bei dieser Vorgehensweise mögen periodisch wiederkehrende Bewölkungsereignisse den Erwartungswert zu bestimmten Sonnenständen beeinflussen. Die Wahrscheinlichkeit, dass die Bewölkung sich aber immer in einer gleichen prozentualen Einbuße einer elektrischen Leistung gegenüber dem idealen Leistungsverlauf auswirkt, ist aber nur minimal. Bei dem neuen Verfahren führt sie praktisch nicht zum falschen Annehmen einer Verschattung.

Dies gilt insbesondere dann, wenn in dem Fall nur eines einzigen Solarmoduls die Verschattungswahrscheinlichkeit für jeden Sonnenstand, an dem die von dem Solarmodul an dem aktuellen Tag bei dem Sonnenstand abgegebene elektrische Leistung den idealen Leistungsverlauf erreicht oder gar überschreitet, auf einen Wert kleiner oder gleich null gesetzt wird, weil das Erreichen der idealen Leistung bei diesem Sonnenstand nur ohne eine Verschattung möglich ist. Werte einer Wahrscheinlichkeit kleiner als null sind nicht unmittelbar von logischem Sinn. Bei einer Mittelung über verschiedene Wahrscheinlichkeitswerte können negative Wahrscheinlichkeitswerte von hohem Gewicht aber durchaus sinnvoll sein, um mutmaßlich falsch positive Wahrscheinlichkeitswerte auszugleichen.

Der Erwartungswert für jeden Sonnenstand an dem aktuellen Tag kann auch als Spitzenwert von normierten elektrischen Leistungen definiert werden, die von mehreren gleichartigen Solarmodulen bei dem jeweiligen Sonnenstand an dem aktuellen Tag abgegeben werden. In diesem Fall nimmt die Höhe der Verschattungswahrscheinlichkeit für jedes Solarmodul mit dem Maß des Unterschreitens des Erwartungswerts durch die von dem jeweiligen Solarmodul bei dem jeweiligen Sonnenstand abgegebene normierte elektrische Leistung zu.

Wenn mehrere Solarmodule und die zugehörigen Leistungsdaten zur Verfügung stehen, muss für die Bestimmung der Erwartungswert der elektrischen Leistung nicht auf einen erwarteten Leistungsverlauf auf der Basis von Messwerten aus der Vergangenheit zurückgegriffen werden. Vielmehr kann als Erwartungswert der normierte aktuelle Spitzenwert der elektrischen Leistungen von den einzelnen Solarmodulen festgelegt werden, wobei der Spitzenwert nicht unbedingt der absolut gesehen höchste aktuelle normierte Wert der Leistung eines einzelnen Solarmoduls sein muss, sondern beispielsweise auch der zweit- oder dritthöchste Wert oder ein Mittelwert über die höchsten Werte sein kann. Eine Gleichartigkeit der Solarmodule ist dabei nur insoweit Voraussetzung, als dass ihre Leistungen relativ zueinander normiert werden können. Die Normierungsvorschrift zur wechselseitigen Abbildung der Leistungen aufeinander kann dabei durchaus komplex sein und muss sich nicht auf einen Proportionalitätsfaktor beschränken.

Indem für den Erwartungswert der elektrischen Leistung für jedes Solarmodul auf aktuelle elektrische Leistungen der Gesamtheit der Solarmodule zurückgegriffen wird, können bei dieser Ausführungsform des neuen Verfahrens nicht nur bei wolkenfreier Sonne sondern auch bei Bewölkung Wahrscheinlichkeitswerte für Verschattungen einzelner Solarmodule bei bestimmten Sonnenständen gewonnen werden, soweit sich trotz der Bewölkung noch eine Schattenbildung einstellt. Diese Möglichkeit muss aber nicht ausgenutzt werden. Vielmehr kann sich auch diese Ausführungsform des neuen Verfahrens bewusst auf die Bestimmung der Wahrscheinlichkeitswerte bei wolkenfreier Sonne und entsprechend maximaler Schattenbildung beschränken, weil auch nur dann wesentliche Energieeinbußen aufgrund einer Verschattung einstellen, was für deren Bewertung von Bedeutung ist.

Bei der Ausführungsform des neuen Verfahrens, bei der der Erwartungswert der elektrischen Leistung für jedes Solarmodul aus den elektrischen Leistungen aller Solarmodule bestimmt wird, kann die Verschattungswahrscheinlichkeit für das jeweilige Solarmodul für jeden Sonnenstand, bei dem die von dem jeweiligen Solarmodul an einem Tag abgegebene elektrische Leistung den Spitzenwert der normierten elektrischen Leistungen von den mehreren gleichartigen Solarmodulen erreicht oder überschreitet, indem es diesen z. B. selbst bereitstellt, auf einen Wert kleiner oder gleich null gesetzt werden. Geht man davon aus, dass keine Verschattungen auftreten, die alle Solarmodule gleichermaßen erfassen, kann ein einzelnes Solarmodul nur dann den Spitzenwert der elektrischen Leistung bei einem bestimmten Sonnenstand bereitstellen, wenn es bei diesem Sonnenstand nicht verschattet ist.

Die von den einzelnen Solarmodulen erzeugte elektrische Spannung allein hat sich als wenig belastbares Kriterium für die Erfassung von Verschattungen eines Solarmoduls erwiesen. Zudem ist sie für eine Beurteilung der Verschattung hinsichtlich der damit verbundenen Energieeinbuße nicht gut geeignet. Wenn jedoch die von jedem Solarmodul erzeugte elektrische Leistung erfasst wird und ein Spannungserwartungswert der von dem Solarmodul erzeugten elektrischen Spannung für jeden Sonnenstand an dem aktuellen Tag definiert wird, kann für alle Sonnenstände, zu denen die von dem Solarmodul während des aktuellen Tages abgegebene elektrische Leistung hinter dem idealen Leistungsverlauf zurückbleibt, ein Faktor von null bis eins für die Verschattungswahrscheinlichkeit festgelegt werden, dessen Größe mit ansteigendem Maß an Abweichung der von dem Solarmodul bei dem jeweiligen Sonnenstand erzeugten elektrischen Spannung von dem Spannungserwartungswert zunimmt. Definiert werden kann der Spannungservvartungswert entweder, wenn mehrere Solarmodule vorhanden sind, durch den Mittelwert oder Median der Spannung von den einzelnen Solarmodulen oder, wenn nur ein Solarmodul vorhanden ist, auf Basis der Spannungen des Solarmoduls zum Zeitpunkt von Spitzenwerten der elektrischen Leistung bei entsprechenden Sonnenständen während der Anzahl von vergangenen Tagen.

In besonders bevorzugten Ausführungsformen der vorliegenden Erfindung wird das Ergebnis des Erkennens und Beurteilens von Verschattungen dem Anwender der jeweiligen Photovoltaikanlage in anschaulicher Form präsentiert. Hierzu können in einer Darstellung des Leistungsverlaufs der von jedem Solarmodul abgegebenen elektrischen Leistung die Sonnenstände gekennzeichnet werden, bei denen eine überwiegende Verschattungswahrscheinlichkeit gegeben ist. Dies kann z. B. bei einer Darstellung des Leistungsverlaufs über den aktuellen Tag, in der der einfachen Zuordbarkeit halber statt der zugehörigen Sonnenstände die Uhrzeiten angegeben sein können, durch leicht zuordbare Symbole erfolgen.

Bei dem erfindungsgemäßen Verfahren kann zumindest für alle Sonnenstände, bei denen die von dem Solarmodul während des aktuellen Tages abgegebene elektrische Leistung hinter dem idealen Leistungsverlauf zurückbleibt und in denen keine überwiegende Verschattungswahrscheinlichkeit gegeben ist, eine Bewölkungswahrscheinlichkeit festgelegt werden. Bei der Bewölkungswahrscheinlichkeit bei diesen Sonnenständen kann es sich im einfachsten Fall um die Differenz der Verschattungswahrscheinlichkeit zu 1 handeln.

In der bereits angesprochenen Darstellung des Leistungsverlaufs der von jedem Solarmodul abgegebenen Leistung können dann auch die Sonnenstände gekennzeichnet werden, bei denen eine überwiegende Bewölkungswahrscheinlichkeit gegeben ist. Leistungseinbußen gegenüber dem idealen Leistungsverlauf, der auch selbst dargestellt werden kann, aber nicht dargestellt werden muss, sind auf diese Weise leicht zuzuordnen.

Zusätzlich können in einer Darstellung des Leistungsverlaufs der von jedem Solarmodul abgegebenen elektrischen Leistung die Energiemengen, die gegenüber dem idealen Leistungsverlauf nicht generiert werden konnten, angegeben werden. D. h., aus der Darstellung des Leistungsverlaufs sind damit der Grund und der Umfang der gegenüber dem idealen Leistungsverlauf nicht generierten Leistungen ersichtlich. Allerdings ist die während eines bestimmten Tages nicht generierte elektrische Leistung wenig aussagekräftig. Eine sehr aussagekräftige Darstellung entsteht jedoch, wenn die Verschattungswahrscheinlichkeiten zu den Sonnenständen in eine Jahressonnenstandsübersichtskarte eingetragen werden. Idealerweise wird dabei auf einer Achse der Azimuth-Winkel des Sonnenstands aufgetragen, während auf der anderen Achse der Höhenwinkel des Sonnenstands aufgetragen wird. Daraus kann die Lage von Verschattungshindemissen gegenüber dem jeweiligen Solarmodul direkt abgelesen werden. Wenn die genauen Sonnenstände und dergleichen Informationen nicht verfügbar sind, können die Verschattungswahrscheinlichkeiten hilfsweise über der Tageszeit auf der einen Achse und der Jahreszeit auf der anderen Achse aufgetragen werden, wobei eine halbjährige Betrachtung ausreichend ist. Die Verschattungswahrscheinlichkeiten können über diesen beiden Achsen beispielsweise in Form von Farbstufen codiert wiedergegeben werden.

Um statistische Streuungen noch weiter in ihrer Auswirkung zu reduzieren, kann die Verteilung der Verschattungswahrscheinlichkeiten über die Jahressonnenstandsübersichtskarte durch Mittelung über benachbarte Werte geglättet werden. Anschließend kann die Verteilung der Verschattungswahrscheinlichkeiten über die Jahressonnenstandsübersichtskarte nach überwiegenden Verschattungswahrscheintichkeiten gefiltert werden. Hierfür ist ein geeigneter Grenzwert der Verschattungswahrscheinlichkeiten, ab dem von einer überwiegenden Verschattungswahrscheinlichkeit auszugehen ist, festzusetzen. Nach der Filterung weist die Jahressonnenstandsübersichtskarte die Sonnenstände aus, bei denen eine Verschattung des jeweiligen Solarmoduls wahrscheinlich gegeben ist.

Zu diesen Bereichen der Jahressonnenstandsübersichtskarte mit überwiegender Verschattungswahrscheinlichkeit wird vorzugsweise die zugehörige Jahresenergieverlustmenge aufgrund der Verschattung angegeben. So wird eine Entscheidungsgrundlage für die mögliche Entfernung von Verschattungshindernissen oder eine andere Anordnung der Solarmodule bereitgestellt. Im Detail kann dabei insbesondere ein unterer Höhenwinkel des Sonnenstands des Bereichs, für den die zugehörige Jahresenergieverlustmenge angegeben wird, willkürlich festgelegt werden. Dieser untere Sonnenstandshöhenwinkel entspricht beispielsweise der Höhe, auf die ein Baum gekürzt werden könnte. Die zugehörige Jahresenergieverlustmenge gibt an, wie viel zusätzliche Energie hierdurch im vergangenen Jahr hätte generiert werden können.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile von erfindungsgemäßen Ausführungsformen zwingend erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden.

### KURZBESCHREIBUNG DER FIGUREN

Die Erfindung wird im Folgenden unter Bezugnahme auf die beigefügten Zeichnungen anhand von Ausführungsbeispielen näher erläutert und beschrieben.
- **Fig. 1**: skizziert den realen Leistungsverlauf eines Solarmoduls über einen Tag, wobei Gründe für eine Abweichung von einem idealen Leistungsverlauf bei wolken- und schattenfreier Sonne über den ganzen Tag durch Symbole angegeben sind.
- **Fig. 2**: ist ein Ablaufdiagramm zur Durchführung des neuen Verfahrens.
- **Fig. 3**: stellt für einen aktuellen Tag den realen Verlauf der von einem Solarmodul abgegebenen elektrischen Leistung einem erwarteten Leistungsverlauf und einem idealen Leistungsverlauf über den Tag gegenüber.
- **Fig. 4**: ist eine Auftragung von Verschattungswahrscheinlichkeiten dargestellt in Graustufen in einer Jahressonnenstandsübersichtskarte, längs deren X-Achse der Azimuth-Winkel des Sonnenstands und längs deren Y-Achse der Höhenwinkel des Sonnenstands aufgetragen ist; und
- **Fig. 5**: ist eine Jahressonnenstandsübersichtskarte, in der die Verschattungswahr scheinlichkeiten eines Solarmoduls nach Filterung mit einem Grenzwert für die Verschattungswahrscheinlichkeit wiedergegeben sind und zu den Bereichen des Sonnenstands mit überwiegender Verschattungswahrscheinlichkeit die hiermit verbundenen Energiemindermengen angegeben sind.

### FIGURENBESCHREIBUNG

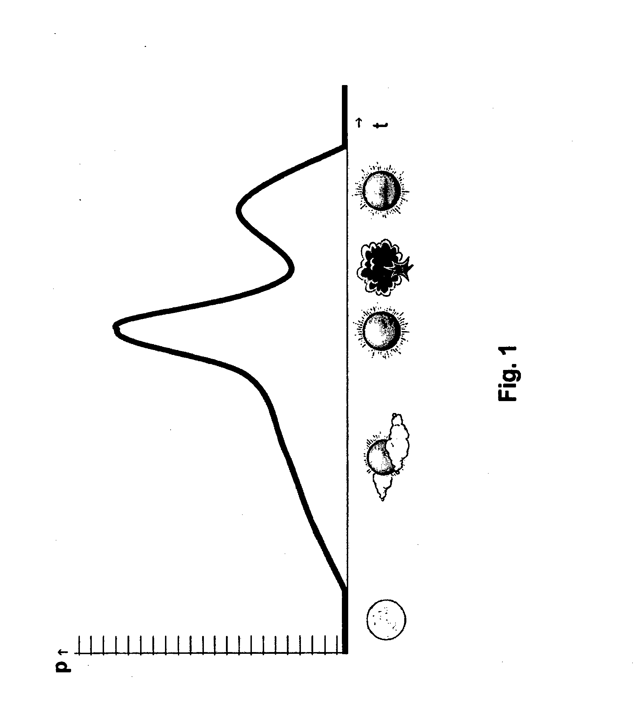

Der in **Fig. 1** skizzierte reale Verlauf der elektrischen Leistung eines Solarmoduls entspricht nur dann einem idealen Leistungsverlauf über den Tag, wenn das Solarmodul wolkenfreier Sonne ohne schattenbildende Hindernisse ausgesetzt ist. Diese Zeiträume sind in Fig. 1 mit einem Sonnensymbol an der X-Achse markiert. Am Vormittag des betrachteten Tages war die Sonne hingegen bewölkt, wodurch die tatsächlich abgegebene elektrische Leistung reduziert war. Am Nachmittag fällt ein Schatten auf das Solarmodul, so dass trotz wolkenfreier Sonne die unter idealen Umständen mögliche Leistung nicht erzielt wurde. Dieser Bereich ist längs der X-Achse durch ein Baumsymbol markiert. Das Mondsymbol an der X-Achse weist auf Nachtzeit ohne Licht hin. Fig. 1 gibt neben dem realen Leistungsverlauf des Solarmoduls das Ergebnis einer Analyse dieses Leistungsverlaufs wieder, die durch das erfindungsgemäße Verfahren durchgeführt wurde.

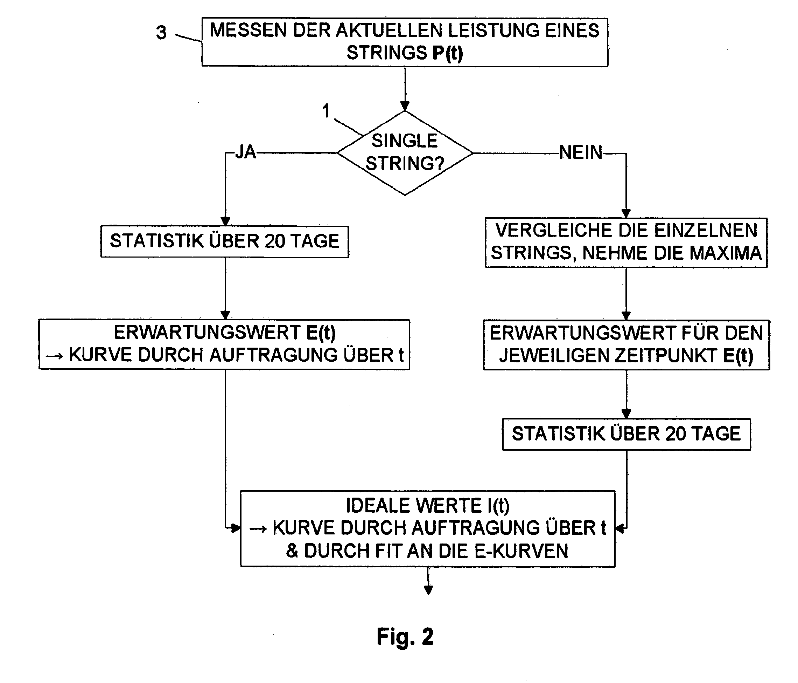

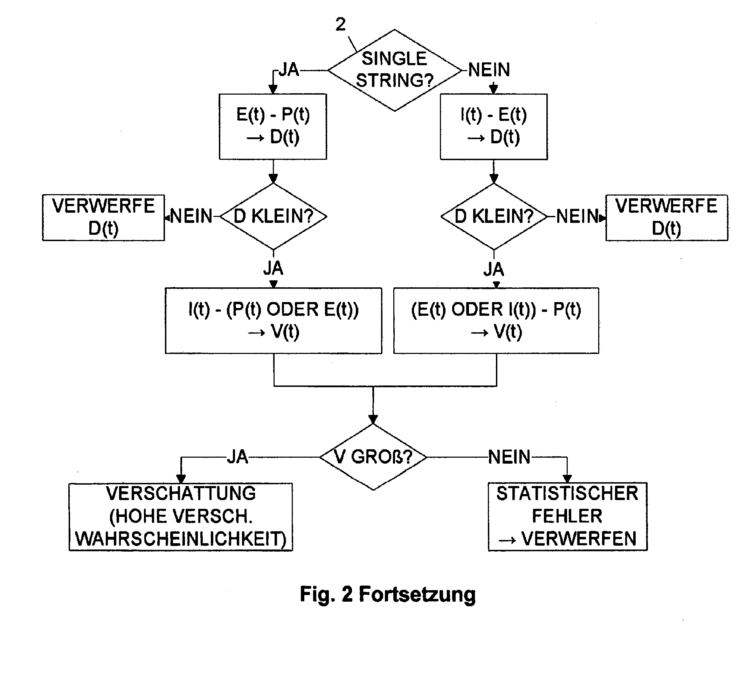

Dieses erfindungsgemäße Verfahren ist in **Fig. 2** als Anlaufdiagramm skizziert. Das Ablaufdiagramm verzweigt sich in zwei Schritten 1 und 2 danach, ob für das Erkennen und Beurteilen von Verschattungen nur jeweils ein Solarmodul zur Verfügung steht, welches hier als String bezeichnet wird, oder ob Messwerte zu mehreren gleichartigen Solarmodulen zur Verfügung stehen. Das Ablaufdiagramm verzweigt jeweils nach links für den Fall nur eines Solarmoduls und nach rechts für den Fall mehrerer gleichartiger Solarmodule. Unabhängig davon wird in jedem Fall in einem ersten Schritt 3 die aktuelle Leistung P(t) jedes Solarmoduls bzw. Strings gemessen. Im Falle nur eines Strings wird über diese Messwerte eine Statistik über ein Zeitraum von 20 Tagen geführt, wobei dieser Zeitraum von 20 Tagen zwar in der Regel geeignet, aber dennoch nur beispielhaft ist und auch kürzer oder länger gewählt werden kann. Aus der Statistik werden Erwartungswerte E(t) der Leistung von dem Solarmodul für einen aktuellen Tag bestimmt. Dazu werden nur Spitzenwerte der elektrischen Leistung P(t) des Solarmoduls während entsprechender Tageszeiten binnen der letzten 20 Tage herangezogen. Aus den Erwartungswerten E(t) wird ein idealer Leistungsverlauf I(t) über den aktuellen Tag durch Anfitten an die Kurve von E(t) bestimmt. Dieser Schritt des Anfittens eines idealen Leistungsverlaufs I(t) an eine von Spitzenwerten bestimmte Kurve ist auch der Vorgehensweise beim Vorhandensein mehrerer Strings zu eigen. Hier wird jedoch der Erwartungswert E(t) für jeden Zeitpunkt als die höchste zur Vergleichbarkeit normierte Leistung P(t) von einem der Strings definiert. Über diese Erwartungswerte E(t) wird für 20 Tage eine Statistik geführt. An die Spitzenwerte dieser Statistik wird der ideale Leistungsverlauf I(t) angefittet. Der ideale Leistungsverlauf I(t) entspricht in beiden Fällen einem idealen Leistungsverlauf bei wolkenfreier Sonne ohne auftretende Verschattungen.

Im Falle nur eines Solarmoduls wird als nächstes eine Differenz D(t) zwischen dem tatsächlichen Leistungswert zum Zeitpunkt t und dem Erwartungswert zum Zeitpunkt t gebildet. Ist diese Differenz D groß, d. h. nicht klein, weil sie zum Beispiel mindesten 20 % oder mindestens 40 % oder mindesten 60 % beträgt, was auf einen bewölkten Tag hinweist, wird der Wert von D(t) verworfen. Falls der Wert von D jedoch klein ist, d. h. der tatsächliche Leistungswert P(t) dem Erwartungswert E(t) entspricht, was auf einen wolkenfreien Tag hinweist, wird eine Differenz V(t) zu der idealen Leistung I(t) zum Zeitpunkt t gebildet. Wenn diese Differenz V groß ist, liegt eine hohe Verschattungswahrscheinlichkeit vor. Ist diese Differenz hingegen klein, wird ein statistischer Fehler angenommen und der Wert verworfen.

Im Falle mehrerer Strings wird zunächst eine Differenz D(t) zwischen dem Erwartungswert zum Zeitpunkt t und dem idealen Leistungswert I(t) zum Zeitpunkt t bestimmt. Wenn diese Differenz klein ist, weist dies wie eine kleine Differenz D(t) bei der parallelen Abfrage im Fall nur eines Strings darauf hin, dass es sich um einen wolkenfreien Tag handelt und sich die weitere Auswertung des Werts von D(t) lohnt. Wenn die Differenz jedoch nicht klein ist, ist dies ein Hinweis auf einen bewölkten Tag, und der Wert von D(t) wird verworfen. Bei kleinem D wird anschließend eine Differenz zwischen dem tatsächlichen Leistungswert P(t) und dem Erwartungswert E(t) oder dem idealen Leistungswert I(t) gebildet. Diese Differenz V(t) wird wieder darauf überprüft, ob sie groß ist, was als Hinweis auf eine Verschattung genommen wird, während kleine Werte von V als statistischer Fehler verworfen werden. Abhängig von der Größe von V können in beiden Fällen, d. h. sowohl bei einem String als auch mehreren Strings Wahrscheinlichkeiten für die Verschattung definiert werden.

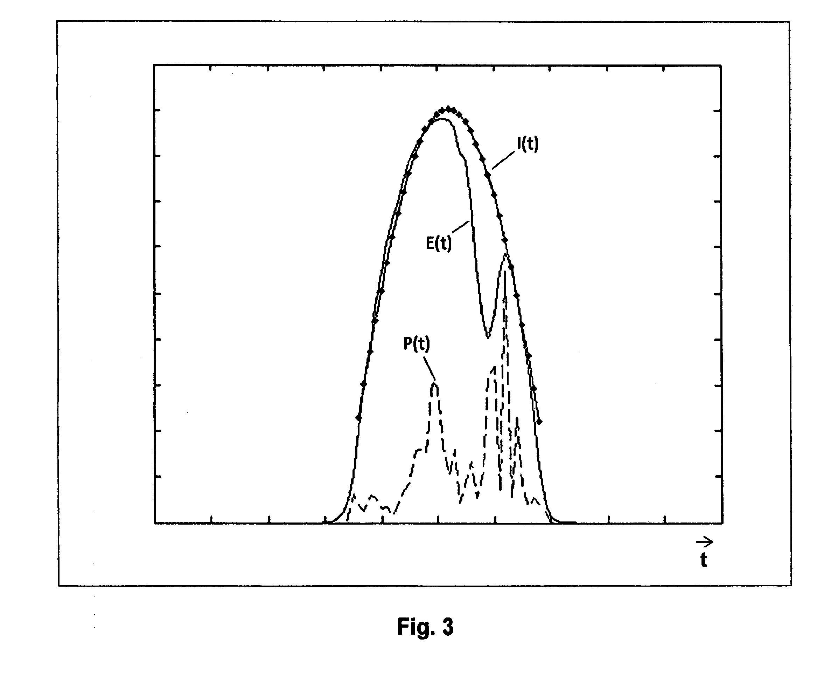

**Fig. 3** ist eine Auftragung verschiedener Leistungskurven über einen Tag. Die unterste, gestrichelte Kurve gibt die tatsächlich gemessene Leistung P(t) eines Solarmoduls wieder. Diese nähert sich punktuell an die erwartete Leistung E(t) des Solarmoduls an, die aus den Spitzenwerten der Leistung P(t) binnen der vergangenen Tage ermittelt wurde. Angefittet an E(t) ist der ideale Leistungsverlauf I(t), der wolkenfreier Sonne ohne schattenbildende Hindernisse über den gesamten Tag entspricht.

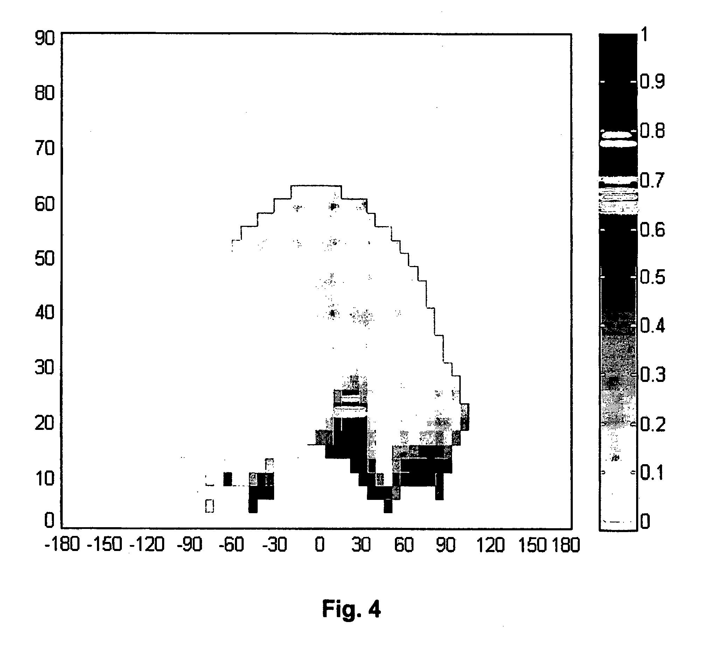

In **Fig. 4** sind die bei dem Verfahren gemäß Fig. 2 ermittelten Wahrscheinlichkeiten für eine Verschattung bei dem zugehörigen Sonnenstand in eine Sonnenstandsübersichtskarte eingetragen, die die Sonnenstände eines ganzen Jahres abdeckt und insoweit auch als Jahressonnenstandsübersichtskarte bezeichnet wird. Dabei ist längs der X-Achse der Azimuth-Winkel des Sonnenstands aufgetragen, während längs der Y-Achse der Höhenwinkel des Sonnenstands aufgetragen ist. Je dunkler die Graustufe ist, desto höher ist die Wahrscheinlichkeit einer Verschattung. Dabei ist die gezeigte Jahressonnenstandsübersichtskarte bereits durch Mittelung über die an den einzelnen Tagen ermittelten Verschattungswahrscheinlichkeiten entstanden. Diese Mittelung kann durch einfache Mittelwertbildung über jedes der gezeigten Felder in der Jahressonnenstandsübersichtskarte durchgeführt sein, wobei nur vorhandene Verschattungswahrscheinlichkeiten berücksichtigt werden, d. h. ein nicht vorhandener Wert nicht als eine Verschattungswahrscheinlichkeit von null in die Mittelwertbildung eingeht.

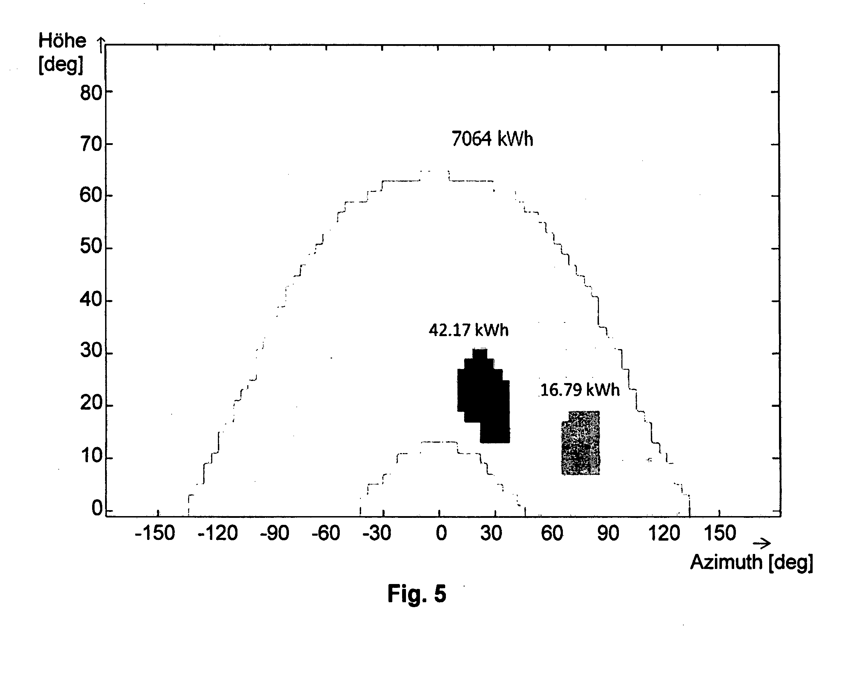

**Fig. 5** gibt die Sonnenstandsübersichtskarte gemäß Fig. 4 nach Kantenfilterung mit einem Grenzwert für eine überwiegende Verschattungswahrscheinlichkeit wieder. Dabei wurden zwei geschlossene Bereiche identifiziert, in denen eine überwiegende Verschattungswahrscheinlichkeit gegeben ist. Zu diesen Bereichen ist die Jahresenergiemenge angegeben, die aufgrund der Verschattung nicht produziert werden konnte. Diese steht im Vergleich zu der Gesamtenergiemenge, wie sie von dem Solarmodul während des Jahres erzeugt wurde. Damit steht ein Kriterium dafür bereit, ob es sinnvoll ist, die festgestellten Verschattungen zu beseitigen. Die die Verschattungen hervorrufenden Hindernisse können aufgrund der Jahressonnenstandsübersichtskarte direkt bestimmten Richtungen von dem jeweiligen Solarmodul aus zugeordnet und konkret identifiziert werden.

## Patentansprüche

1. Verfahren zum Erkennen und Beurteilen von Verschattungen bei mindestens einem Solarmodul mit den Schritten:
- Erfassen der von dem Solarmodul abgegebenen elektrischen Leistung;
- Bestimmen eines idealen Leistungsverlaufs der elektrischen Leistung über einen aktuellen Tag auf Basis der für einander entsprechende Sonnenstände während einer Anzahl von vergangenen Tagen erfassten elektrischen Leistung; und
- Ermitteln von Abweichungen der von dem Solarmodul während des aktuellen Tages abgegebenen elektrischen Leistung von dem idealen Leistungsverlauf;
**dadurch gekennzeichnet,**
- **dass** der ideale Leistungsverlauf wolkenfreier Sonne ohne Schatten werfende Hindernisse über den ganzen Tag entspricht und an Spitzenwerte der für die einander entsprechenden Sonnenstände während der Anzahl von vergangenen Tagen erfassten elektrischen Leistung angefittet wird;
- **dass** für jeden Sonnenstand am aktuellen Tag ein Erwartungswert der von dem Solarmodul abgegebenen elektrischen Leistung definiert wird; und
- **dass** für alle Sonnenstände, bei denen die von dem Solarmodul während des aktuellen Tages abgegebene elektrische Leistung unter dem idealen Leistungsverlauf bleibt, eine Verschattungswahrscheinlichkeit größer oder gleich null festgelegt wird, deren Höhe von dem Maß an Übereinstimmung der von dem Solarmodul bei dem Sonnenstand abgegebenen elektrischen Leistung mit dem Erwartungswert abhängt.

2. Verfahren nach Anspruch 1, **dadurch gekennzeichnet, dass** der Erwartungswert für jeden Sonnenstand als Spitzenwert der elektrischen Leistung bei den ihm entsprechenden Sonnenständen während der Anzahl von vergangenen Tagen definiert wird und dass die Höhe der Verschattungswahrscheinlichkeit mit ansteigendem Maß an Übereinstimmung der von dem Solarmodul bei dem jeweiligen Sonnenstand abgegebenen elektrischen Leistung mit dem Erwartungswert zunimmt.

3. Verfahren nach Anspruch 2, **dadurch gekennzeichnet, dass** die Verschattungswahrscheinlichkeit für jeden Sonnenstand, bei dem die von dem Solarmodul an einem Tag abgegebene elektrische Leistung den idealen Leistungsverlauf erreicht oder überschreitet, auf einen Wert kleiner oder gleich null gesetzt wird.

4. Verfahren nach Anspruch 1, **dadurch gekennzeichnet, dass** der Erwartungswert für jeden Sonnenstand als Spitzenwert von normierten elektrischen Leistungen definiert wird, die von mehreren gleichartigen Solarmodulen bei dem jeweiligen Sonnenstand an dem aktuellen Tag abgegeben werden, und dass die Höhe der Verschattungswahrscheinlichkeit für jedes Solarmodul mit ansteigendem Unterschreiten des Erwartungswerts durch die von dem jeweiligen Solarmodul bei dem jeweiligen Sonnenstand abgegebene normierte elektrische Leistung zunimmt.

5. Verfahren nach Anspruch 4, **dadurch gekennzeichnet, dass** die Verschattungswahrscheinlichkeit für das jeweilige Solarmodul für jeden Sonnenstand, bei dem die von dem jeweiligen Solarmodul an einem Tag abgegebene elektrische Leistung den Spitzenwert der normierten elektrischen Leistungen von den mehreren gleichartigen Solarmodulen erreicht oder überschreitet, auf einen Wert kleiner oder gleich null gesetzt wird.

6. Verfahren nach mindestens einem der vorhergehenden Ansprüche, **gekennzeichnet durch** die zusätzlichen Schritte:
- Erfassen der von dem Solarmodul erzeugten elektrischen Spannung;
- Definieren eines Spannungserwartungswerts der von dem Solarmodul erzeugten elektrischen Spannung für jeden Sonnenstand an dem aktuellen Tag;
- für alle Sonnenstände, zu denen die von dem Solarmodul während des aktuellen Tages abgegebene elektrische Leistung hinter dem idealen Leistungsverlauf zurückbleibt, Festlegen eines Faktors von null bis eins für die Verschattungswahrscheinlichkeit, dessen Größe mit ansteigendem Maß an Abweichung der von dem Solarmodul bei dem jeweiligen Sonnenstand erzeugten elektrischen Spannung von dem Spannungserwartungswert zunimmt.

7. Verfahren nach mindestens einem der vorhergehenden Ansprüche, **dadurch gekennzeichnet, dass** in einer Darstellung des Leistungsverlaufs der von dem Solarmodul abgegebenen Leistung die Sonnenstände gekennzeichnet werden, bei denen eine überwiegende Verschattungswahrscheinlichkeit gegeben ist.

8. Verfahren nach mindestens einem der vorhergehenden Ansprüche, **dadurch gekennzeichnet, dass** zumindest für alle Sonnenstände, bei denen die von dem Solarmodul während des aktuellen Tages abgegebene elektrische Leistung hinter dem idealen Leistungsverlauf zurückbleibt und in denen keine überwiegende Verschattungswahrscheinlichkeit gegeben ist, eine Bewölkungswahrscheinlichkeit festgelegt wird.

9. Verfahren nach Anspruch 8, **dadurch gekennzeichnet, dass** in einer Darstellung des Leistungsverlaufs der von dem Solarmodul abgegebenen Leistung die Sonnenstände gekennzeichnet werden, bei denen eine überwiegende Bewölkungswahrscheinlichkeit gegeben ist.

10. Verfahren nach Anspruch 7 oder 9, **dadurch gekennzeichnet, dass** in der Darstellung des Leistungsverlaufs der von dem Solarmodul abgegebenen Leistung die Energiemengen, die gegenüber dem idealen Leistungsverlauf nicht generiert werden konnten, und deren wahrscheinliche Ursache angegeben werden.

11. Verfahren nach mindestens einem der vorhergehenden Ansprüche, **dadurch gekennzeichnet, dass** die Verschattungswahrscheinlichkeiten zu den Sonnenständen in eine Jahressonnenstandsübersichtskarte eingetragen werden.

12. Verfahren nach Anspruch 11, **dadurch gekennzeichnet, dass** die Verteilung der Verschattungswahrscheinlichkeiten über die Jahressonnenstandsübersichtskarte durch Mittelung geglättet wird.

13. Verfahren nach Anspruch 11 oder 12, **dadurch gekennzeichnet, dass** die Verteilung der Verschattungswahrscheinlichkeiten über die Jahressonnenstandsübersichtskarte nach überwiegenden Verschattungswahrscheinlichkeit gefiltert wird.

14. Verfahren nach mindestens einem der vorhergehenden Ansprüche 11 bis 13, **dadurch gekennzeichnet, dass** zu mindestens einem Bereich der Jahressonnenstandsübersichtskarte mit überwiegender Verschattungswahrscheinlichkeit die zugehörige Jahresenergieverlustmenge angegeben wird.

15. Verfahren nach Anspruch 14, **dadurch gekennzeichnet, dass** insbesondere ein unterer Sonnenstandshöhenwinkel des Bereichs, für den die zugehörige Jahresenergieverlustmenge angegeben wird, willkürlich festgelegt wird.

## Claims

1. Method of recognizing and assessing shadowing events at at least one solar module, the method comprising the steps of:
- recording the electric power delivered by the solar module;
- determining an ideal power course of the electric power over a present day on the basis of the electric power recorded for solar altitudes corresponding to each other during a number of previous days; and
- detecting deviations of the electric power delivered by the solar module during the present day from the ideal power course;
**characterized in**
- **that** the ideal power course corresponds to cloudless sun without shadow casting obstacles over the entire day and is fitted to peak values of the electric power recorded for the solar altitudes corresponding to each other during the number of previous days;
- **that** for each solar altitude on the present day an expected value of the electric power delivered by the solar module is defined; and
- **that** for all solar altitudes at which the electric power delivered by the solar module during the present day falls short of the ideal power course, a shadowing probability of higher than or equal to zero is defined, whose height depends on the level of accord of the electric power delivered by the solar module at the solar altitude with the expected value.

2. Method of claim 1, **characterized in that** the expected value for each solar altitude is defined as a peak value of the electric power at the solar altitudes corresponding to it during the number of previous days and that the height of the shadowing probability increases with increasing level of accord of the electric power delivered by the solar module at the respective solar altitude with the expected value.

3. Method of claim 2, **characterized in that** the shadowing probability for each solar altitude at which the electric power delivered by the solar module on one day reaches or exceeds the ideal power course is set to a value smaller than or equal to zero.

4. Method of claim 1, **characterized in that** the expected value for each solar altitude is defined as a peak value of normalized electric powers which are delivered by several similar solar modules at the respective solar altitude on the present day and that the height of the shadowing probability for each solar module increases with increasing undershooting the expected value by the normalized electric power delivered by the respective solar module at the respective solar altitude.

5. Method of claim 4, **characterized in that** the shadowing probability for the respective solar module for each solar altitude at which the electric power delivered by the respective solar module on a day reaches or exceeds the peak value of the normalized electric powers from the several similar solar modules is set to a value smaller than or equal to zero.

6. The method of at least one of the preceding claims, **characterized by** the additional steps:
- recording the electric voltage generated by the solar module;
- defining an expected voltage value of the electric voltage generated by the solar module for each solar altitude on the present day;
- for all solar altitudes at which the electric power delivered by the solar module during the present day falls short of the ideal power course, defining a factor in the range from zero to one for a shadowing probability whose height increases with increasing level of deviation of the electric voltage generated by the solar module at the respective solar altitude from the expected voltage value.

7. Method of at least one of the preceding claims, **characterized in that**, in a display of the power course of the power delivered by the solar module, those solar altitudes are indicated at which a predominant shadowing probability is given.

8. Method of at least one of the preceding claims, **characterized in that**, at least for all solar altitudes at which the electric power delivered by the solar module during the present day falls short of the ideal power course and at which no predominant shadowing probability is given, a clouding probability is defined.

9. Method of claim 8, **characterized in that**, in a display of the power course of the power delivered by the solar module those solar altitudes are indicated at which a predominant clouding probability is given.

10. Method of claim 7 or 9, **characterized in that**, in the display of the power course of the power delivered by the solar module, the amounts of energy which could not be generated as compared to the ideal power course, and their probable cause are indicated.

11. Method of at least one of the preceding claims, **characterized in that** the shadowing probabilities for the solar altitudes are entered in an annual solar altitude overview map.

12. Method of claim 11, **characterized in that** the distribution of the shadowing probabilities over the annual solar altitude overview map are smoothened by averaging.

13. Method of claim 11 or 12, **characterized in that** the distribution of the shadowing probabilities over the annual solar altitude overview map are filtered for predominant shadowing probability.

14. Method of at least one of the preceding claims 11 to 13 **characterized in that**, for at least one area of the annual solar altitude overview map with predominant shadowing probability, an associated annual amount of energy loss is indicated.

15. Method of claim 14, **characterized in that** particularly a lower solar altitude elevation angle of the range for which the associated annual amount of energy loss is indicated is set arbitrarily.

## Revendications

1. Procédé de reconnaissance et d'évaluation d'obscurcissements dans au moins un module solaire, comprenant les étapes consistant à:
- observer la puissance électrique délivrée par le module solaire;
- déterminer une évolution idéale de la puissance électrique au cours d'une journée effective sur la base de la puissance électrique observée pendant un nombre défini de jours précédents pour des positions du soleil mutuellement correspondantes; et
- calculer des écarts de la puissance électrique délivrée par le module solaire pendant la journée effective par rapport à l'évolution idéale de la puissance; **caractérisé**
- **en ce que** l'évolution idéale de la puissance correspond à un soleil sans nuage sans obstacles projetant une ombre pendant la journée complète et est adaptée à des valeurs de crête de la puissance électrique observée pour les positions du soleil mutuellement correspondantes pendant le nombre défini de jours précédents;
- **en ce qu'**une valeur de prévision de la puissance électrique délivrée par le module solaire est définie pour chaque position du soleil pendant la journée effective; et
- **en ce que** pour toutes les positions du soleil auxquelles la puissance électrique délivrée par le module solaire au cours de la journée effective reste inférieure à une évolution idéale de la puissance, une probabilité d'obscurcissement supérieure ou égale à zéro est établie, dont le niveau dépend du degré de concordance de la puissance électrique délivrée par le module solaire dans la position du soleil concernée avec la valeur de prévision.

2. Procédé selon la revendication 1, **caractérisé en ce que** la valeur de prévision pour chaque position du soleil est définie comme valeur de crête de la puissance électrique dans les positions du soleil correspondantes pendant le nombre défini de jours précédents et **en ce que** le niveau de la probabilité d'obscurcissement augmente à mesure de l'élévation du degré de concordance de la puissance électrique délivrée par le module solaire dans la position du soleil concernée avec la valeur de prévision.

3. Procédé selon la revendication 2, **caractérisé en ce que** la probabilité d'obscurcissement est fixée à une valeur inférieure ou égale à zéro pour chaque position du soleil dans laquelle la puissance électrique délivrée par le module solaire au cours d'une journée atteint ou dépasse l'évolution idéale de la puissance.

4. Procédé selon la revendication 1, **caractérisé en ce que** la valeur de prévision est définie pour chaque position du soleil comme valeur de crête de puissances électriques normalisées qui sont délivrées par plusieurs modules solaires du même type dans la position du soleil concernée au cours de la journée effective et **en ce que** le niveau de la probabilité d'obscurcissement augmente pour chaque module solaire à mesure que la valeur de prévision descend en dessous de la puissance électrique normalisée délivrée par le module solaire respectif dans la position respective du soleil.

5. Procédé selon la revendication 4, **caractérisé en ce que** la probabilité d'obscurcissement est fixée à une valeur inférieure ou égale à zéro pour le module solaire respectif pour chaque position du soleil dans laquelle la puissance électrique délivrée par le module solaire respectif au cours d'une journée atteint ou dépasse la valeur de crête des puissances électriques normalisées des plusieurs modules solaires du même type.

6. Procédé selon au moins une des revendications précédentes, **caractérisé par** les étapes supplémentaires consistant à:
- observer la tension électrique produite par le module solaire;
- définir une valeur de prévision de tension de la tension électrique produite par le module solaire pour chaque position du soleil au cours de la journée effective;
- pour toutes les positions du soleil dans lesquelles la puissance électrique délivrée par le module solaire au cours de la journée effective reste inférieure à l'évolution idéale de la puissance, fixer un facteur de zéro à un pour la probabilité d'obscurcissement, dont la valeur augmente à mesure que la tension électrique produite par le module solaire dans la position du soleil concernée s'écarte de la valeur de prévision de la tension.

7. Procédé selon au moins une des revendications précédentes, **caractérisé en ce que** dans une représentation de l'évolution de la puissance délivrée par le module solaire, les positions du soleil dans lesquelles il existe une probabilité d'obscurcissement prépondérante sont identifiées.

8. Procédé selon au moins une des revendications précédentes, **caractérisé en ce qu'**au moins pour toutes les positions du soleil dans lesquelles la puissance électrique délivrée par le module solaire au cours de la journée effective reste inférieure à l'évolution idéale de la puissance et dans lesquelles il n'existe pas de probabilité d'obscurcissement prépondérante, une probabilité de nébulosité est fixée.

9. Procédé selon la revendication 8, **caractérisé en ce que** dans une représentation de l'évolution de la puissance délivrée par le module solaire, les positions du soleil dans lesquelles il existe une probabilité de nébulosité prépondérante sont identifiées.

10. Procédé selon la revendication 7 ou 9, **caractérisé en ce que** dans la représentation de l'évolution de la puissance délivrée par le module solaire, les quantités d'énergie qui n'ont pas pu être produites par rapport à l'évolution idéale de la puissance et leur cause probable sont indiquées.

11. Procédé selon au moins une des revendications précédentes, **caractérisé en ce que** les probabilités d'obscurcissement relatives aux positions du soleil sont inscrites dans une carte récapitulative annuelle des positions du soleil.

12. Procédé selon la revendication 11, **caractérisé en ce que** la répartition des probabilités d'obscurcissement sur la carte récapitulative annuelle des positions du soleil est lissée par le biais d'une formation de moyennes.

13. Procédé selon la revendication 11 ou 12, **caractérisé en ce que** la répartition des probabilités d'obscurcissement sur la carte récapitulative annuelle des positions du soleil est filtrée en fonction de la probabilité d'obscurcissement prépondérante.

14. Procédé selon au moins une des revendications 11 à 13, **caractérisé en ce que** pour au moins une zone de la carte récapitulative annuelle des positions du soleil comprenant la probabilité d'obscurcissement prépondérante, la quantité de perte d'énergie annuelle correspondante est indiquée.

15. Procédé selon la revendication 14, **caractérisé en ce qu'**en particulier un angle inférieur de la hauteur de la position du soleil est fixé arbitrairement pour la zone pour laquelle la quantité de perte d'énergie annuelle correspondante est indiquée.
